(19) Europäisches Patentamt

European Patent Office

Office européen des brevets

(11) EP 0 998 044 A2

(12) **EUROPEAN PATENT APPLICATION**

(43) Date of publication:
03.05.2000 Bulletin 2000/18

(51) Int. Cl.$^7$: **H03L 7/099**

(21) Application number: **99500178.1**

(22) Date of filing: **06.10.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.10.1998 ES 9802258**

(71) Applicant: **Telefonica, S.A.**
**28013 Madrid (ES)**

(72) Inventors:
- **Olmos González, Pedro**
**28028 MADRID (ES)**
- **Merayo Fernández, Luis Antonio**
**28028 MADRID (ES)**

(74) Representative:
**Carpintero Lopez, Francisco**
**HERRERO & ASOCIADOS, S.L.**
**Alcalá, 21**
**28014 Madrid (ES)**

(54) **Clock retriever based on direct digital synthesis for the adaptive method**

(57) A clock retriever designed for ATM (Asynchronous Transfer Mode) systems which need to maintain timing end to end based on the adaptive method, consisting of applying digital processing techniques and oscillators based on direct digital synthesis (DDS) in design of the retriever, which allows retrieval practically between a direct current signal and a maximum frequency with a considerably improved frequency resolution.

FIG.2

EP 0 998 044 A2

## Description

### OBJECT OF THE INVENTION

The present invention relates to a clock retriever for constant rate services when carried by an Asynchronous Transfer Mode (ATM) network, based on application of digital processing techniques and use of Direct Digital Synthesis (DDS) in clock retrieval based on the adaptive method, and not to the method itself or to the production of a DDS-based generator, which have been developed some time ago.

The adaptive method operates depending on how full an FIFO memory is. If in a certain time interval more data have entered the FIFO than have left (fill level increases) the frequency is increased, and in the opposite case it is decreased.

Applying digital processing and oscillators based on Direct Digital Synthesis (DDS) of frequencies to the clock retriever allows retrieving practically between direct current and a maximum with a greater frequency resolution and clock retriever characteristics much better than those possible for the present analog system.

The scope of application of the invention is the field of telecommunications, and more specifically systems which operate with the Asynchronous Transfer Mode (ATM) technology, which require maintaining the time reference end to end, and as a specific example systems with a type 1 adaptation layer.

### BACKGROUND OF THE INVENTION

Among the clock retrieval methods known in the previous technique are the SRTS (Synchronous Residual Time Stamp) and the adaptive method for clock retrieval at the remote end, with the latter being the most widely used.

The invention is meant to introduce improvements over the above mentioned adaptive method, which is now performed based on a Phase Locked Loop (PLL) with a crystal oscillator controlled by an analog voltage (VCXO, Voltage Controlled Crystal Oscillator).

The PLL control consists of evaluating the difference between a pair of counters, and based on the value and sense of this difference it is decided whether the frequency must be increased or reduced. The value obtained is sent to a D/A (digital/analog) converter to extract the analog control signal for the VCXO. The loop characteristics, as with all PLL systems, are set by the low-pass filter.

The main disadvantage of this system is that it can be used only for the VCXO operational frequency, so that if it has to be used for a given number of frequencies there must be an oscillator for each frequency to be generated. In addition, the PLL loop characteristics would change for each frequency, which may force to alter the low-pass filter for each particular case, which is practically impossible with analog components.

The use of simple voltage controlled oscillators (without a crystal) does not solve this problem, as the time characteristics of the retrieved frequency (jitter and wander) are worsened, since this oscillator would have a much higher transfer function, in Hertz per Volts, and therefore any small signal or noise results in a greater deviation of the frequency. In addition, voltage controlled oscillators (VCO) can operate only within a given frequency range (maximum and minimum frequency).

Applying a method based on DDS allows to solve both of these problems, in addition to substantially improving the system. The following advantages have been found in the implementation of this system:

- The possibility of generating any frequency, practically between direct current and a maximum frequency with a very small frequency resolution. The range of frequencies generated is as many octaves as bits-1 of the phase accumulator. The maximum frequency will be set by a value equal to half of that of an external clock.

- The time characteristics (jitter and wander) of the output clock are fully controllable, since these parameters depend on the PLL transfer function, and this in turn depends on those of the low-pass filter. In an analog system the low-pass filter is fixed and cannot be changed dynamically, while in a digital system the low-pass filter characteristics may be changed over time (there can even be a non-linear transfer (function), and in addition it allows use of processors which can be given the necessary software for performing this function. It is therefore possible to change the transfer function for each frequency that is to be generated.

- It is not necessary that the receiver be aware of the output frequency since it can be adapted to any, as long as it is within the limits of the generator.

- It is not necessary for the system to have a type 1 adaptation layer. Since all system parameters are controllable by software the clock can be retrieved although the data come from type 0, type 2 or even type 3/4 and 5 MTA cells.

The applicant is not aware of the existence of an invention with the characteristics described above.

### DESCRIPTION OF THE DRAWINGS

These and other characteristics of the invention will be made clear in reading the detailed description which follows of a preferred embodiment, given for purposes of illustration and in a non limiting nature, made with reference to the drawings enclosed, in which:

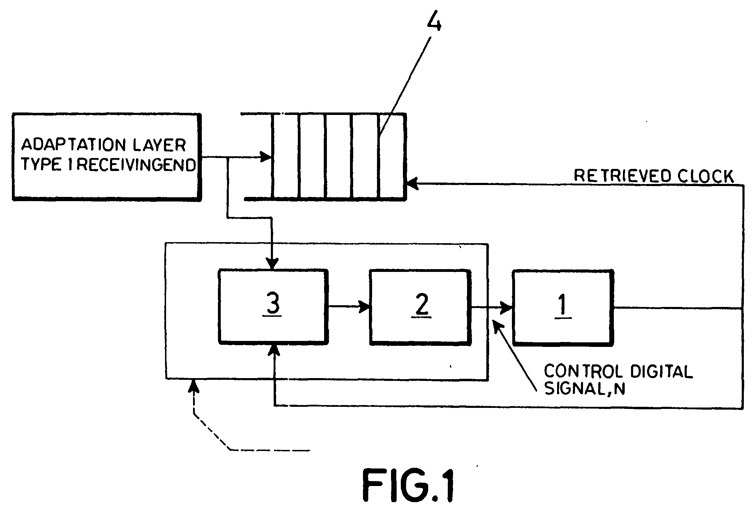

Figure 1 shows a block diagram of the clock generation using the direct digital synthesis technique used by the invention, and

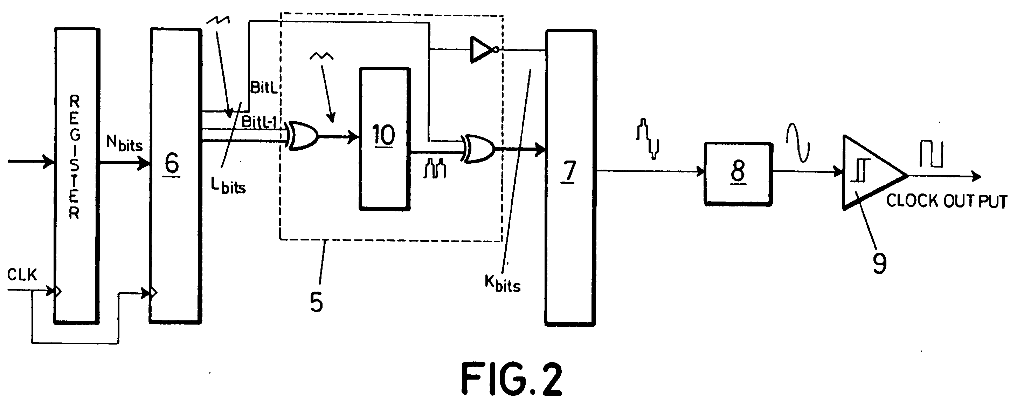

Figure 2 also shows a block diagram of the complete system of the present invention.

## DESCRIPTION OF THE INVENTION

The invention, of which a preferred embodiment will be described in detail here with reference to the Figures, relates to a clock retriever which consists of replacing the digital/analog converter, the analog low-pass filter and the voltage controlled oscillator by a certain binary datum based on direct digital synthesis (DDS) (1). Digital low-pass filter (2) replaces the analog one and DDS (1) acts as a voltage controlled oscillator. All of this can be controlled by a processor with the appropriate software; it can also be controlled by hardware, although this is always less flexible.

The clock retriever mechanism functions with the adaptive method, that is, it is based on the filling level of a given FIFO buffer memory (4), so that if in a certain time period more data have been introduced than extracted, the output clock frequency shall be increased, and decreased in the opposite case.

The clock generation is done by the direct digital synthesis (DDS) method. This method allows not only to retrieve the clock but also to operate at practically any frequency between almost direct current and a maximum value.

In the operation of the mechanism, the output of low-pass digital filter (2) is written in the input of DDS (1); N; this value is entered in an accumulator (6) so that at each clock cycle the output is increased by this value. The output of accumulator (6) is the instantaneous phase values, which are taken to a table which in practice is implemented by a ROM memory (10), where a sine function is stored, as a sine function is completely symmetrical it is not necessary to store a full cycle in the ROM (10) of table (5), but only a quadrant, one quarter of it will suffice (from 0 to 90 degrees) as will be described below, so that phase values are converted into amplitude values in each clock cycle. These values are sent to a digital/analog converter (7), at whose output is obtained a sine signal of the required frequency. This signal must be filtered by a low-pass filter (8) to eliminate the unwanted low-frequency components due to the sampling process itself (alias). As the signal generated must be used to work as a clock in a digital system, the filter output is sent to a Schmitt trigger (9) which changes it into a square signal, which is the signal which will be used as the retrieved clock of the service frequency.

It must be remarked that the function of low-pass filter (8) of the DDS is only to cancel the unwanted frequencies (Nyquist frequency) and not to set the locking characteristics of the loop. The loop characteristics will be set by digital low-pass filter (2) placed at the DDS input.

The most significant bit of the accumulator (6) output is a square signal of the same frequency as the one desired but which cannot be used since its spurious response is deficient, as it has many components at frequencies next to the one which must be generated, which results in signal jitter. This signal can only be used in two cases: when the desired frequency is very small respect to that of the clock, and when the generated frequency is an integer sub-multiple of the clock's. In general, we will not be in any of these two particular cases.

In a system of this type frequency resolution is determined by the size of the phase accumulator and is calculated with the formula:

$$F_{step} = F_{clk} / 2^M$$

where M is the number of bits of the phase accumulator and $F_{clk}$ is the reference frequency at the input of accumulator (6). This is also the minimum frequency which the system can generate, as the output frequency is determined by the expression:

$$F_{sal} = (F_{clk}/2^M)N; \text{ therefore } F_{sal} = F_{step} N$$

where N is the value at the input of accumulator (6). It can be seen therefore that the output frequency is a function of the input value.

As regards the maximum frequency, it is determined by the Nyquist frequency, i.e. $F_{clk}/2$; however, this value has been limited to approximately one third of the clock frequency in order to properly filter the spurious frequencies caused due to the sampling process. The greater the synthesised frequency, the nearer the remaining spectral components, which makes filtering more difficult.

In any event the spurious frequencies of a system with DDS are discrete frequencies, rather than the "wideband" noise of a system with analog PLL.

In a system with DDS (assuming an ideal D/A converter) the frequency resolution is given by the size of the accumulator (6), as previously described. Spectral purity is set by the number of words of ROM (10) (width of its addresses: $2^L$), so that this value specifies the number of points per sine cycle, that is, the phase resolution. On its part, the signal/noise (S/N) ratio is set by the size in bits of the data bus of the table (S/N = 6K + 5). These different bit widths are not in general equal. The only limitations are that the address widths cannot be greater than the accumulator size, obviously, and that the S/N ratio cannot be improved by increasing the size of the bus output table more than two bits more than the addresses bus. For the system of the invention, the S/N ratio value does not affect the clock characteristics as much, since the signal will be later converted into a square signal to operate the logic.

One must also keep in mind that spectral purity worsens with the ratio $F_{sal}/F_{clk}$ since the number of points per period of the signal is reduced, this being another reason why it is not convenient to generate frequencies above 1/3 of the clock frequency.

The spectral purity inherent to a system of these characteristics is set by the quality of the master clock [the clock at the input of accumulator (6)] which is used. From the point of view of spectral purity, a DDS oscillator can be considered as a system which divides the master frequency by a value which may not be an integer, so that the theoretical spectral purity which can be obtained is less than that of the master clock, since the spurious response is also divided by this value.

In order to realise the adaptive method it is enough to make small changes round the central service frequency, which is equivalent to slightly changing the value of N. This change can be normally made once per cell, but the low-pass filter may change this value in order to improve the clock's jitter and wander in network overload conditions. That is, if the network causes loss of cells or a very high variable delay of these, the clock quality is considerably worsened, and in order to prevent this an average is made over a greater number of cells, since the effect of the loss of one cell is divided among the number averaged. As relates to the variable delay effect, avenging reduces it greatly, since if certain cells arrive with a greater delay the next ones will necessarily have a smaller delay (if none are lost).

The receiver may even be unaware of the arriving frequency and perform adjustments in the frequency until finding the correct one. In this case the filter transfer function may even be non-linear, in order to reach the correct value in the shortest possible time, without overflowing or emptying the output buffer.

As was described above, it is not necessary to store an entire sine cycle in the ROM memory (10) of check table (5), but only one quarter of it, and thus having a large check table (5) is avoided. This system of reducing the size of the table is based on the symmetry of sine signals. The signal between 0 and 180 degrees is symmetrical about zero, the signal having two parts with identical shape but opposite sign. In addition, a semi-cycle is also symmetrical with respect to 90 degrees, so that the signal is the same between 0 and 90 degrees as between 90 and 180, but inverted.

Thus, in the first quadrant the input addresses in the table are rising, while between 90 and 180 degrees they are inverted and decrease until reaching zero; when the mid point of the cycle is reached the output is inverted and the process repeated, so that the full cycle is generated. The ROM (10) only stores data corresponding to the first quadrant (between 0 and 90 degrees).

This system of reducing the size of table (5) is implemented by XOR gates placed respectively at the input and output of ROM (10). These gates act as controlled inverters, so that if an input of an XOR gate is assigned as controlled inverter it may or may not invert the other input: if the control input is at zero level, there is no inversion, and if it is at 1 there is inversion.

The two most significant bits in the first quadrant are worth 00, the table is read in a rising sense, and the output is not inverted. When the second quadrant is reached the most significant bits are worth 01, so that the table input addresses are inverted, with the output of accumulator (6) rising always, but the table input addresses are inverted and therefore they are decreasing. The addresses follow the same path as in the input but decreasing until reaching zero. At this moment the third quadrant of the sine wave is reached. Now the most significant bits are at 10. The output data are inverted and the input addresses are not, so that the operation is the same as for the first quadrant but with the output sign inverted. In the fourth quadrant the most significant bits are worth 11, the output is inverted and the addresses too, so that the operation is the same as for the second quadrant but with the output inverted.

The inverter at the output in the most significant bit is because this inverted bit directly constitutes the output, since this bit indicates only the sign of the signal: 1 positive, 0 negative; as accumulator (6) begins at zero, it is inverted.

**Claims**

1. Clock retriever based on direct digital synthesis (DDS) for the adaptive method, this method consisting of the variation of the output clock frequency depending on the filling level of a certain buffer memory (4) (FIFO), which can be used in systems for transport of services which require maintaining timing end to end in an asynchronous transfer mode (ATM) network, and particularly in those with a type 1 adaptation layer, characterised in that it comprises a digital low-pass filter (2) and an oscillator (1) controlled by a certain binary datum based on direct digital synthesis (DDS), which advantageously replaces the analog low-pass filter and the voltage controlled oscillator of the previous technique, with the output of such digital low-pass filter connected to an accumulator (6) which is increased with every clock cycle and having at its output instantaneous phase values which may be sent to a table (5), preferably implemented by a read-only memory (10), in which the phase values become amplitude values in each clock cycle, and where these values are processed by a digital/analog converter (7) in order to obtain a signal of the required frequency at the output of said converter which, after being filtered by a low -pass filter (8), is applied to a Schmitt trigger (9) to obtain at its output a square signal which can be used as a retrieved clock of the service frequency.

2. Clock retriever as in claim 1, characterised in that said DDS oscillator (1) can operate at any frequency between a value near direct current (DC) and a certain maximum frequency value.

FIG.1

REGISTER

CLK

$N_{bits}$

6

BitL

BitL-1

$L_{bits}$

10

5

$K_{bits}$

7

8

9

CLOCK OUTPUT

**FIG.2**

EP 0 998 044 A2